# FASCICULE DE BREVET EUROPEEN

(11) **EP 0 382 650 B1**
(45) Date de publication et mention de la délivrance du brevet: **28.07.1993**
(21) Numéro de dépôt: 90420026.8
(22) Date de dépôt: 17.01.1990
(51) Int. Cl.: F16B 37/04, H05K 7/18

(54) **Dispositif de fixation par vissage sur un profile ferme, notamment d'une armoire électrique**
Befestigungsvorrichtung durch Zusammenschrauben auf einem Profil, insbesondere auf einem Elektrizitätsschrank
Device for fixation by screwing on a closed structure, especially an electrical cabinet

(30) Priorité: 07.02.1989 FR 8901663
(43) Date de publication de la demande: 16.08.1990
(73) Titulaire: MERLIN GERIN, F-38240 Meylan (FR)
(72) Inventeur: Xavs, Luis, F-38050 Grenoble Cédex (FR); Muset, José Maria, F-38050 Grenoble Cédex (FR)
(74) Mandataire: Ritzenthaler, Jacques

(56) Documents cités:
- EP-A- 0 146 072
- DE-A- 2 549 868
- FR-A- 1 431 766
- US-A- 2 635 667
- US-A- 4 120 231

## Description

L'invention est relative à un dispositif de fixation selon le préambule de la revendication 1.

Les armoires d'appareillage électrique comportent généralement une ossature constituée par l'assemblage de profilé creux sur lesquels sont fixés des traverses ou des supports d'appareils, ou tout autre élément constitutif de l'armoire. Chaque profilé généralement de forme tubulaire creuse, de section polygonale, présente sur ses faces latérales des rangées de perforations permettant une fixation par vissage en différents emplacements. Il est difficile d'introduire un écrou dans le profilé fermé et d'amener cet écrou en regard de la perforation recevant la vis de fixation. On connait un dispositif de fixation par vissage faisant usage de profilés, dont les perforations sont taraudées, ce qui permet une fixation aisée par simple vissage d'une vis dans la perforation. La fabrication de tels profilés est coûteuse et, seuls certains taraudages sont effectivement utilisés.

Il a déjà été proposé d'utiliser des vis auto-taraudeuses, se vissant dans la perforation du profilé. Cette solution est valable pour des profilés d'une épaisseur de tôle relativement importante, et elle ne convient qu'à des fixations ne nécessitant aucun ou peu de démontage par la suite.

On connait également des écrous-cage insérés dans la perforation et maintenus par clipsage. Les dimensions de la perforation sont nettement plus grandes que celles de l'écrou, ce qui affaiblit le profilé. Les cages présentent des pattes prenant appui sur la face externe du profilé, et ces pattes en saillie peuvent constituer une gêne pour la fixation d'éléments.

Le document DE-A-2.549.868 décrit un dispositif de fixation dans lequel l'écrou est porté par un support allongé pouvant être introduit dans la perforation et dont la tête vient en appui de la bordure de la perforation. L'écrou est monté à pivotement et à coulissement axial sur le support. Après pivotement de l'écrou pour le placer parallèlement à la paroi, il est déplacé axialement par serrage de la vis pour l'amener en appui de la paroi. Le support doit être bien plus long que l'épaisseur de la paroi et il ne peut être mis en place à l'avance.

Il a déjà été proposé de prévoir dans le profilé des ouvertures en regard des différentes perforations permettant d'introduire l'écrou et de le maintenir en regard de la perforation jusqu'au vissage par la vis traversant la perforation. Les ouvertures dans le profilé peuvent être des perforations spéciales, ce qui complique la fabrication du profilé ou des perforations ménagées sur une autre face du profilé. Dans ce cas, cette perforation servant à l'introduction de l'écrou n'est plus disponible pour une fixation, ce qui limite les possibilités d'utilisation du profilé.

La présente invention a pour but de permettre la réalisation d'un dispositif de fixation ne nécessitant aucune disposition spéciale, pouvant être mis en place à l'avance,et permettant une utilisation de l'ensemble des perforations pour une fixation d'éléments, et ce but est atteint par la mise en oeuvre des particularités de la partie caractéristique de la revendication 1.

L'écrou est monté à pivotement sur un support susceptible d'être glissé dans une perforation du profilé, l'écrou étant placé de chant pendant la manoeuvre d'insertion dans la perforation. L'écrou est généralement de forme rectangulaire et en le plaquant de chant, il suffit que la largeur de la perforation soit légèrement supérieure à celle de l'écrou, et que la hauteur de la perforation soit supérieure à l'épaisseur de l'écrou, pour permettre le passage de ce dernier à travers la perforation. La longueur de l'écrou peut être quelconque, notament plus grande que la hauteur de la perforation. Après passage de l'écrou, ce dernier est pivoté de 90°, par exemple à l'aide d'un tournevis, pour venir se placer parallèlement à la face arrière du profilé à l'intérieur de ce dernier. Un simple coulissement de l'écrou parallèlement à cette face, permet un centrage de l'écrou qui vient en appui par ses bords longitudinaux sur la bordure de la perforation. La fixation de l'élément est effectuée de la manière usuelle, par une simple vis se vissant dans l'écrou disposé à l'intérieur du profilé. Le support est avantageusement en tôle pliée, et il comporte une partie élargie limitant l'introduction de l'ensemble support-écrou à travers la perforation, cette partie élargie étant par exemple constituée par deux pattes recourbées venant se plaquer sur la face du profilé en bordure de la perforation.

Les perforations recevant les écrous pivotants et coulissants selon l'invention peuvent être plus petites que les perforations conçues pour des écrous-cages, et ces perforations peuvent recevoir des écrous pour des vis de différents diamètres. Le dispositif de fixation n'empiète pas sur les autres zones de fixation, qui restent disponibles pour la fixation d'autres éléments, notamment sur une face adjacente.

Selon un développement important de l'invention, le support est commun à deux écrous, l'un étant monté fixe sur le support, et l'autre étant monté pivotant et coulissant de la manière précisée ci-dessus. Les deux écrous coopèrent avec des perforations ménagées sur des faces adjacentes du profilé, le support et les deux écrous étant introduits par une même perforation, en prenant soin que le deuxième écrou fixe soit disposé de chant pendant la phase d'introduction à l'intérieur du profilé. Le support est conformé de manière qu'après verrouillage de l'écrou coulissant sur le profilé, l'écrou fixe vienne en regard de la perforation correspondante de l'autre face du profilé. L'emploi d'un support commun à deux écrous évite toute saillie sur la deuxième face de fixation et simplifie le montage de l'armoire. Il est clair que le support peut porter un troisième écrou, si le profilé présente une troisième face munie de perforations de fixation, ou éventuellement un nombre supérieur selon la section du profilé. Les perforations sont de préférence toutes de mêmes dimensions pour permettre l'introduction du support avec ses écrous par l'une quelconque de ces perforations. Dans le cas d'un profilé de section carrée, les quatre faces peuvent être munies de perforations rectangulaires ou carrées, s'échelonnant par exemple sur toute la hauteur du profilé. Lorsque ce profilé constitue l'un des montants de l'armoire, il est ainsi possible de fixer à une hauteur quelconque, une traverse de support d'appareillage électrique, cette traverse s'étendant dans l'une ou l'autre direction perpendiculaire au profilé. L'écrou pivotant porte avantageusement deux tourillons alignés, chacun introduit dans une fente allongée, ménagée dans le support de manière à permettre d'une part un pivotement de l'écrou autour de l'axe constitué par les deux tourillons, et d'autre part un coulissement par déplacement des tourillons dans les fentes. Une disposition inverse, en l'occurrence d'ergots portés par le support et pénétrant dans des rainures latérales de l'écrou, est bien entendu concevable.

Le même profilé peut bien entendu recevoir des supports à un seul écrou et des supports à deux écrous, un de ces écrous étant éventuellement inutilisé. Les perforations sur les différentes faces du profilé sont de préférence rectangulaires ou carrées et disposées à la même hauteur, mais des dispositions différentes sont concevables.

D'autres avantages et caractéristiques ressortiront plus clairement de la description qui va suivre, d'un mode de mise en oeuvre de l'invention donné à titre d'exemple non limitatif, et représenté aux dessins annexés dans lesquels:
- la figure 1 est une vue schématique en perspective d'un support à deux écrous selon l'invention;
- la figure 2 est une vue en élévation du support selon la figure 1 monté sur un profilé;
- les figures 3 et 4 sont des coupes respectivement suivant les lignes A-A et B-B de la figure 2;
- les figures 5, 6,et 7 sont des vues identiques à celles de la figure 3, montrant les différentes étapes de mise en place du support à l'intérieur du profilé;
- la figure 8 est une vue en élévation d'une fixation d'une charnière sur un profilé selon l'invention;
- la figure 9 est une coupe suivant la ligne A-A de la figure 8.

Sur les figures, un profilé 10 fermé de section carrée présente sur deux de ces faces adjacentes 12, 14, des rangées de perforations 16, 18 de forme rectangulaire. Le profilé 10 peut constituer un montant d'une armoire électrique sur lequel peuvent être fixées des traverses ou des supports par des vis traversant des perforations appropriées. Les séries de perforations 16,18 sont alignées au centre des faces 12, 14, et chaque paire de perforations 16, 18 est à un même niveau, toutes les perforations étant équidistantes. Il est clair que la section du profilé 10 peut être différente, notamment polygonale, et que des perforations de forme ou de disposition différente peuvent être ménagées sur les faces 12,14, ou sur toute autre face du profilé 10.

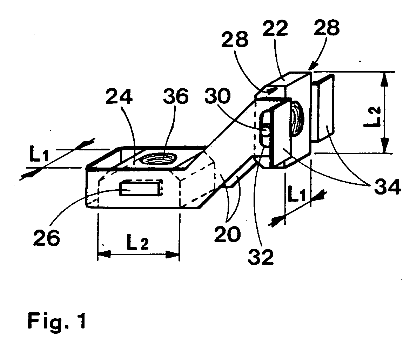

En se référant plus particulièrement à la figure 1, on voit un support 20 de deux écrous 22, 24. Le support est constitué de deux flasques 20 encadrant latéralement les écrous 22, 24, l'écrou 24 étant fixé rigidement aux flasques 20, par exemple par des saillies rectangulaires 26 engagées dans des orifices conjugués des flasques 20. L'écrou 22 porte sur ses faces 28 en regard des flasques 20, des tourillons alignés 30 engagés dans des fentes allongées 32, ménagées dans les flasques 20. Il est facile de voir que l'écrou 22 peut pivoter librement autour de son axe constitué par les tourillons 30 sur le support 20, et peut se déplacer à coulissement dans une direction parallèle aux fentes ou lumières 32. Dans la position représentée sur la figure 1 qui correspond à la position de verrouillage du support 20 à l'intérieur du profilé 10, les deux écrous 22,24 s'étendent dans des plans perpendiculaires et les deux flasques 20 sont prolongés du côté de l'écrou pivotant 22 par deux pattes 34, repliées en équerres. Chaque écrou 22,24 comporte un orifice central 36 taraudé, susceptible de recevoir à vissage une vis de fixation 38. Les écrous 22,24 sont de forme générale rectangulaire d'une largeur L1 inférieure à la longueur L2. L'écrou pivotant et coulissant 22 est mobile dans le sens longitudinal par coulissement dans les lumières 32. La longueur L3 des perforations 16,18 est légèrement supérieure à la largeur l1 des écrous 22,24 pour permettre une insertion du support 20 avec ses écrous 22,24, la largeur L1 étant augmentée par l'épaisseur des flasques du support 20. Pour permettre cette insertion, la largeur L4 des perforations 16,18 est supérieure à l'épaisseur des écrous 22,24, mais inférieure à la longueur L2 de l'écrou pivotant 22.

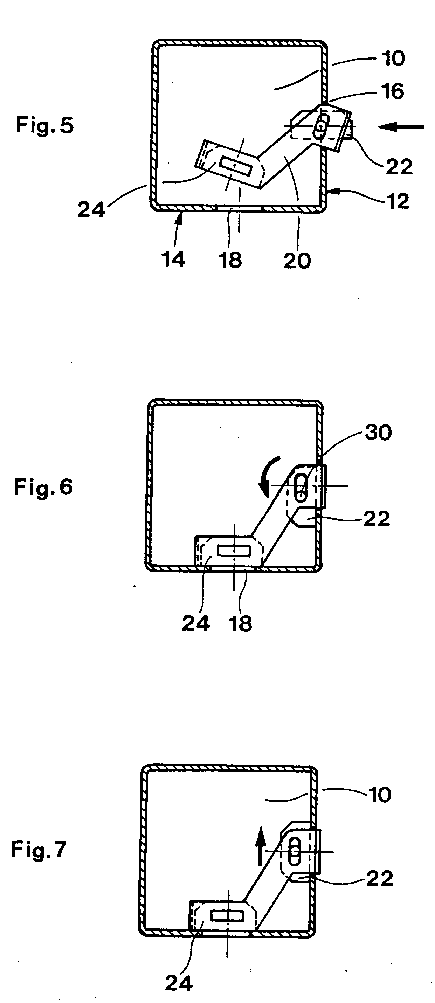

La mise en place du support 20 avec les deux écrous 22,24 est réalisée de la manière suivante, représentée aux figures 5 à 7:

Le support 20 est introduit par le côté portant l'écrou fixe 24 dans la perforation 16, l'écrou 24 se présentant de chant et l'écrou pivotant 22 est disposé perpendiculairement à la face 12 du profilé 10 pour pénétrer également dans la perforation 16 au cours du mouvement poursuivi d'introduction du support 20 à l'intérieur du profilé 10, (figure 5). En fin d'introduction du support 20, les pattes 34 viennent en appui de la face 12, l'écrou fixe 24 venant en regard de la perforation 18 de la face 14.

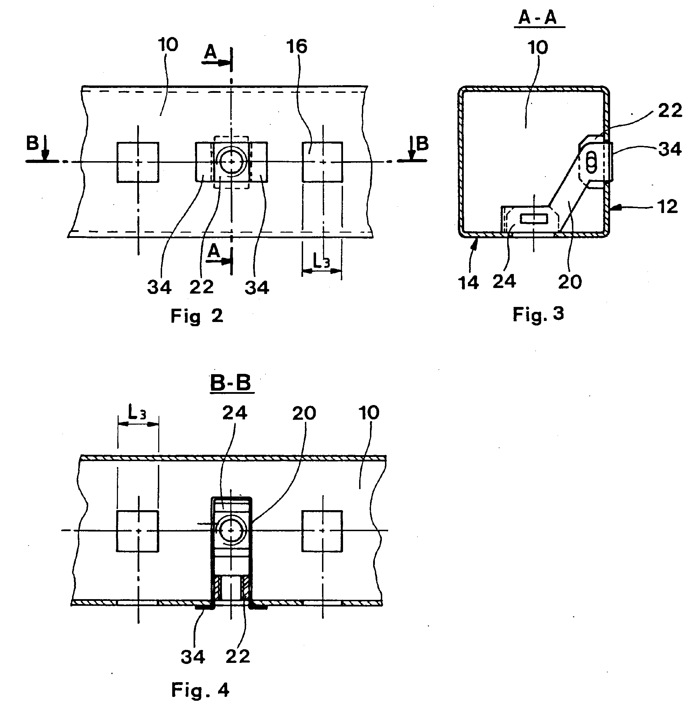

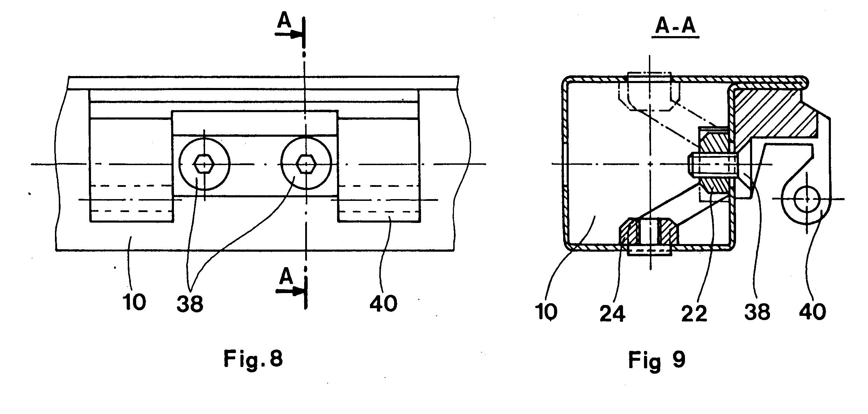

L'écrou pivotant 22 est coulissé vers le bas sur la figure 6 et en même temps pivoté de 90° pour se placer parallèlement à la face interne du profilé 10. Ce mouvement de pivotement est autorisé par le décentrage de l'écrou pivotant 22 par rapport à la perforation 16, et un coulissement vers le haut sur les figures 6 et 7 de l'écrou pivotant 22, amène ce dernier en regard de la perforation 16, les bords longitudinaux prenant appui sur les deux bordures de cette perforation 16, de manière à verrouiller le support 20 dans la position représentée à la figure 7, à l'intérieur du profilé 10. Le mouvement de pivotement et/ou de coulissement de l'écrou pivotant 22, peut être réalisé manuellement, par exemple à l'aide d'un outil ou d'un tournevis. Les écrous 22,24 sont prêts à recevoir des vis de fixation 38, par exemple d'une charnière 40 schématiquement représentée aux figures 8 et 9. Après serrage des vis 38, le support 20 est rigidement solidarisé au profilé 10, cette fixation étant néanmoins facilement démontable par simple dévissage. Dans le cas d'un profilé symétrique, notamment carré du type illustré à la figure 9, le support 20 a deux écrous peut être indifféremment mis en place pour coopérer avec l'une quelconque des faces du profilé, toutes ces faces présentant des perforations identiques. Il est même possible d'introduire deux supports 20 à l'intérieur du profilé 10 à un même niveau pour permettre une fixation sur chacune des faces du profilé 10. En se référant plus particulièrement à la figure 3, on voit que l'une 12 des faces du profilé 10 présente une légère surépaisseur due aux pattes 34 du support 20, la face conjuguée 14 étant par contre dépourvue de toute surépaisseur.

En choisissant judicieusement la perforation par laquelle est introduit le support 20, il est possible de disposer d'une face dépourvue de surépaisseur pour la fixation de certains éléments n'acceptant pas de telles surépaisseurs.

L'invention à été décrite en application à un support 20 à deux écrous, mais il est clair qu'elle peut être utilisée pour un support à un seul écrou pivotant et coulissant 22. Le support est dans ce cas simplifié et se limite à un étrier ayant deux pattes repliées 34 venant se plaquer sur la bordure des perforations de la manière décrite ci-dessus. Toutes les perforations du profilé 10 peuvent être équipées d'un tel écrou pivotant et coulissant 22, ce qui permet une fixation sur une face quelconque d'éléments ou de supports. L'emploi d'un support à écrou unique est néanmoins plus compliqué, et présente l'inconvénient d'une surépaisseur sur la face recevant l'écrou.

Le support 20 qui assure un rôle temporaire de maintien des écrous 22,24 peut être réalisé en tôle pliée, de faible épaisseur et de faible rigidité, la fixation des écrous 22,24 étant réalisée dès le serrage des vis 38. La forme de ce support 20 est bien entendu adaptée à celle du profilé 10, et elle permet le libre pivotement de 90° de l'écrou pivotant 22 ainsi que son coulissement dans les fenêtres allongées 32. Le support pourrait porter trois écrous ou un nombre supérieur dans le cas d'un profilé polygonal à plus de quatre faces, et l'invention est bien entendu applicable à des écrous de formes différentes, par exemple éllipsoïdale ou polygonale. Une perforation d'une dimension de 11/12mm est suffisante pour des vis d'un diamètre de 6 ou 8mm. L'invention est applicable à des armoires électriques, notamment à ossature constituée par un assemblage de profilés 10, sur lesquels sont fixés les supports des appareils ou d'autres éléments de l'armoire. Le système de fixation selon l'invention permet une fixation rapide et fiable, par vissage à différentes hauteurs du profilé 10 et sur l'une quelconque de ses faces. Le démontage est facilement réalisable par simple dévissage. Le support 20 avec les écrous 22,24 peut être récupéré et être disposé en un emplacement différent.

## Revendications

1. Dispositif de fixation d'éléments (40) par vissage sur un profilé (10) creux de section fermée ayant une vis (38) traversant une perforation (16,18) de fixation ménagée sur l'une des faces (12,14) du profilé (10), un écrou (22,24) inséré à l'intérieur du profilé (10)et dans lequel est vissée la vis (38) en position de fixation, et un support (20) sur lequel l'écrou (22) est monté à pivotement et à coulissement, ledit support (20) ayant une partie rétrécie, dont la dimension est inférieure à celle de ladite perforation (16), pour permettre une introduction du support (20) avec l'écrou (22) dans la perforation (16) de fixation lorsque l'écrou (22) est en position pivotée de chant perpendiculaire à la face (12) dudit profilé, et une partie élargie (34) dont au moins une dimension est supérieure à celle de la perforation pour coopérer avec la face du profilé (10) en bordure de la perforation (16) et limiter la pénétration du support (20),caractérisé en ce que l'écrou est monté à coulissement sur le support parallèlement à ladite face du profilé pour permettre après le passage de l'écrou (22) à travers la perforation (16) un pivotement de 90° de ce dernier, suivi d'un coulissement parallèlement à la face pour verrouiller le support (20) et l'écrou (22) sur le profilé (10), l'écrou (22) étant en face de la vis.

2. Dispositif de fixation selon la revendication 1, caractérisé en ce que l'écrou (22) et la perforation (16) sont de forme générale rectangulaire ou carrée et que l'une (11) des dimensions de l'écrou (22) est légèrement plus petite que l'une (13) des dimensions correspondantes de la perforation (16) et que l'autre dimension (12) de l'écrou (22) est plus grande que l'autre dimension (14) correspondante de la perforation (16).

3. Dispositif de fixation selon la revendication 2, caractérisé en ce que l'écrou (22) est monté à pivotement sur un axe (30) perpendiculaire à ladite autre dimension (12) de l'écrou et que l'écrou (22) est monté à coulissement dans une direction parallèle à ladite autre dimension (12).

4. Dispositif de fixation selon la revendication 1,2 ou 3, caractérisé en ce que la partie élargie dudit support comporte deux pattes (34) repliées venant se plaquer en position de fixation sur la face (12) du profilé (10) en bordure de la perforation (16).

5. Dispositif de fixation selon l'une quelconque des revendications précédentes, caractérisé en ce que l'écrou (22) porte sur deux de ses faces opposées deux tourillons alignés (30) formant l'axe de pivotement de l'écrou, chaque tourillon (30) étant engagé dans une lumière (32) allongée ménagée dans un flasque du support (20) encadrant l'écrou (22), lesdites lumières (32) s'étendant parallèlement à la face correspondante du profilé.

6. Dispositif de fixation selon l'une quelconque des revendications précédentes, pour un profilé (10) ayant deux faces de fixation (12,14) chacune pourvue de perforations (16,18), caractérisé en ce que ledit support (20) est commun à deux écrous (22,24), l'un (22) des écrous étant monté à pivotement et à coulissement sur ledit support (20) et coopérant avec une perforation (16) de l'une (12) desdites faces et l'autre (24) des écrous étant monté fixe sur le support (20) de manière à venir à l'intérieur du profilé (10) en regard d'une perforation (18) de l'autre (14) des faces en position verrouillée du support sur le profilé (10).

7. Dispositif de fixation selon la revendication 6, caractérisé en ce que lesdites deux faces (12,14) sont perpendiculaires et que les écrous (22,24) portés par ledit support (20) coopérant avec des perforations (16,18) disposées à un même niveau le long dudit profilé (10).

8. Dispositif selon la revendication 6 ou 7, caractérisé en ce que les perforations (16,18) sont de mêmes dimensions, le support (20) avec les écrous (22,24) pouvant être introduit indifféremment à l'intérieur du profilé (10) par l'une ou par l'autre des perforations (16,18).

9. Dispositif de fixation selon l'une quelconque des revendications précédentes caractérisé en ce que le support (20) est en tôle pliée encadrant le ou les écrous (22,24).

## Patentansprüche

1. Vorrichtung zur Schraubbefestigung von Elementen (40) an einem Hohlprofil (10) mit geschlossenem Querschnitt, die eine Schraube (38) zur Durchführung durch eine in eine der Flächen (12, 14) des Profils (10) eingearbeitete Befestigungsbohrung (16, 18), eine in das Innere des Profils eingebrachte Mutter (22, 24) zur Aufnahme der Schraube (38) in der Befestigungsstellung und einen Tragkörper (20) umfaßt, in dem die Mutter (22) schwenkbar und gleitend verschiebbar montiert ist, wobei der genannte Tragkörper (20) einen schmalen Bereich, dessen Maß geringer ist als das der genannten Bohrung (16), so daß ein Einbringen des Tragkörpers (20) mit der Mutter (22) in die Befestigungsbohrung (16) möglich ist, wenn sich die Mutter (22) in der verschwenkten Hochkantstellung rechtwinklig zur Fläche (12) des genannten Profils (10) befindet, sowie einen verbreiterten Bereich (34) besitzt, an dem mindestens ein Maß größer ist als das der Bohrung, so daß es mit der die Bohrung (16) umschließenden Fläche des Profils (10) zusammenwirken kann und die Eindringtiefe des Tragkörpers (20) begrenzt, dadurch gekennzeichnet, daß die Mutter auf dem Tragkörper parallel zur genannten Fläche des Profils verschiebbar montiert ist, so daß nach dem Einführen der Mutter (22) durch die Bohrung (16) ein Verschwenken der Mutter um 90° und ein nachfolgendes Verschieben parallel zur Fläche möglich ist, um den Tragkörper (20) und die Mutter (22) auf dem Profil (10) fest zu verriegeln, wobei die Mutter (22) gegenüber der Schraube plaziert ist

2. Befestigungsvorrichtung nach Anspruch 1, dadurch gekennzeichnet, daß die Mutter (22) und die Bohrung (16) eine rechtekkige oder quadratische Form haben und daß eines (11) der Malle der Mutter geringfügig kleiner ist als eines (13) der entsprechenden Maße der Bohrung (16) und daß das andere Maß (12) der Mutter (22) größer ist als das entsprechende andere Maß (14) der Bohrung (16).

3. Befestigungsvorrichtung nach Anspruch 2, dadurch gekennzeichnet, daß die Mutter (22) schwenkbar auf einer Achse (30) montiert ist, die senkrecht zum genannten anderen Maß (12) der Mutter verläuft und daß die Mutter (22) parallel zum genannten anderen Maß (12) verschiebbar montiert ist.

4. Befestigungsvorrichtung nach Anspruch 1, 2 oder 3, dadurch gekennzeichnet, daß der verbreiterte Bereich des genannten Tragkörpers zwei Winkellaschen (34) aufweist, die in der Befestigungsstellung auf der Fläche (12) des Profils (10) seitlich der Bohrung (16) aufliegen.

5. Befestigungsvorrichtung nach irgendeinem der oben genannten Ansprüche, dadurch gekennzeichnet, daß die Mutter (22) auf zwei gegenüberliegenden Seiten zwei fluchtend angeordnete Zapfen (30) aufweist, die die Schwenkachse der Mutter bilden, wobei jeder Zapfen von einem in einen Schenkel des Tragkörpers an den Seiten der Mutter (22) eingearbeiteten Langloch (32) aufgenommen wird und die genannten Langlöcher (32) parallel zu der entsprechenden Fläche des Profils verlaufen.

6. Befestigungsvorrichtung nach irgendeinem der oben genannten Ansprüche für ein Profil (10) mit zwei Befestigungsflächen (12, 14), wobei jede Fläche Bohrungen (16, 18) aufweist, dadurch gekennzeichnet, daß der genannte Tragkörper (20) zwei Muttern (22, 24) trägt, wobei eine der Muttern (22) schwenkbar und gleitend verschiebbar auf dem genannten Tragkörper (20) montiert ist und mit einer Bohrung (16) einer der genannten Flächen (12) zusammenwirkt und die andere Mutter (24) feststehend auf dem Tragkörper (20) montiert ist, so daß sie in der auf dem Profil verriegelten Stellung des Tragkörpers im Hohlraum des Profils (10) hinter einer Bohrung (18) der anderen (14) Fläche liegt.

7. Befestigungsvorrichtung nach Anspruch 6, dadurch gekennzeichnet, daß die beiden genannten Flächen (12, 14) rechtwinklig zueinander stehen und daß die beiden auf dem mit den Bohrungen (16, 18) zusammenwirkenden Tragkörper (20) angebrachten Muttern (22, 24) im genannten Profil (10) auf einer Ebene angeordnet sind.

8. Befestigungsvorrichtung nach Anspruch 6 oder 7, dadurch gekennzeichnet, daß die Bohrungen (16, 18) dieselben Maße haben, so daß der Tragkörper (20) mit den Muttern (22, 24) gleichermaßen durch die eine oder die andere Bohrung (16, 18) in das Profil (10) eingebracht werden kann.

9. Befestigungsvorrichtung nach irgendeinem der oben genannten Ansprüche, dadurch gekennzeichnet, daß der Tragkörper (20) aus um die Mutter bzw. die Muttern (22, 24) gebogenem Blech besteht.

## Claims

1. A device for fixing elements (40) by screwing onto a hollow profiled section (10) of closed section having a screw (38) passing through a fixing perforation (16, 18) arranged on one of the faces (12, 14) of the profiled section (10), a nut (22, 24) inserted inside the profiled section (10) and into which the screw (38) is screwed in the fixing position, and a support (20) on which the nut (22) is mounted with pivoting and sliding, said support (20) having a narrowed part, whose size is smaller than that of said perforation (16), to enable a support (20) with the nut (22) to be inserted in the fixing perforation (16) when the nut (22) is in the pivoted edgewise position perpendicular to the face (12) of said profiled section, and an enlarged part (34) at least one dimension of which is greater than the perforation to cooperate with the face of the profiled section (10) at the edge of the perforation (16) and to limit penetration of the support (20), characterized in that the nut is slidingly mounted on the support parallel to said face of the profiled section to allow 90° pivoting of the nut (22) after the latter has passed through the perforation (16), followed by sliding parallel to the face to lock the support (20) and nut (22) onto the profiled section (10), the nut (22) being facing the screw.

2. The fixing device according to claim 1, characterized in that the nut (22) and perforation (16) are of general rectangular or square shape and that one (11) of the dimensions of the nut (22) is slightly smaller than one (13) of the corresponding dimensions of the perforation (16) and that the other dimension (12) of the nut (22) is larger than the other corresponding dimension (14) of the perforation (16).

3. The fixing device according to claim 2, characterized in that the nut (22) is pivotally mounted on an axis (30) perpendicular to said other dimension (12) of the nut and that the nut (22) is slidingly mounted in a direction parallel to said other dimension (12).

4. The fixing device according to claim 1, 2 or 3, characterized in that the enlarged part of said support comprises two folded lugs (34) which in the fixing position are flattened against the face (12) of the profiled section (10) at the edge of the perforation (16).

5. The fixing device according to any one of the above claims, characterized in that the nut (22) bears on two of its opposing faces two aligned trunnions (30) forming the pivoting axis of the nut, each trunnion (30) being engaged in an elongated aperture (32) arranged in a support flange (20) framing the nut (22), said apertures (32) extending parallel to the corresponding face of the profiled section.

6. The fixing device according to any one of the above claims, for a profiled section (10) having two fixing faces (12, 14) each provided with perforations (16, 18), characterized in that said support (20) is common to two nuts (22, 24), one (22) of the nuts being mounted with pivoting and sliding on said support (20) and cooperating with a perforation (16) of one (12) of said faces and the other (24) of the nuts being mounted fixed on the support (20) in such a way as to come inside the profiled section (10) up opposite a perforation (18) of the other (14) of the faces in the locked position of the support on the profiled section (10).

7. The fixing device according to claim 6, characterized in that said two faces (12, 14) are perpendicular and that the nuts (22, 24) supported by said support (20) cooperate with perforations (16, 18) arranged on one level along said profiled section (10).

8. The device according to claim 6 or 7, characterized in that the perforations (16, 18) are of the same dimensions, the support (20) with the nuts (22, 24) being able to be inserted indifferently into the profiled section (10) via one or the other of the perforations (16, 18).

9. The fixing device according to any one of the above claims, characterized in that the support (20) is made of folded sheet metal framing the nut or nuts (22, 24).
